# EUROPEAN PATENT APPLICATION

(11) **EP 3 686 674 A1**
(43) Date of publication of application: **29.07.2020**
(21) Application number: 19154047.5
(22) Date of filing: 28.01.2019
(51) Int. Cl.: G03F 7/20, G03F 7/38

(54) **LITHOGRAPHIC METHOD AND SYSTEM, AND INLINE ELECTRON BEAM FLOODING TOOL**

(71) Applicant: ASML Netherlands B.V., 5500 AH Veldhoven (NL)
(72) Inventor: BATISTAKIS, Chrysostomos, 5500 AH Veldhoven (NL); DILLEN, Hermanus Adrianus, 5500 AH Veldhoven (NL); MAAS, Ruben Cornelis, 5500 AH Veldhoven (NL); VAN KRAAIJ, Markus Gerardus Martinus Maria, 5500 AH Veldhoven (NL)
(74) Representative: Peters, John Antoine

(57) **Abstract**

A lithographic method comprises providing a patterning device being capable of imparting a radiation beam with a pattern in its cross-section to form a patterned radiation beam; projecting by the radiation beam the pattern from the patterning device onto a substrate to provide a patterned substrate, and flooding the patterned substrate by an electron beam.

An electron beam flooding tool is arranged to flood a patterned substrate by an electron beam. The electron beam flooding tool may be arranged in line in a lithographic system.

## Description

### FIELD OF THE INVENTION

The present invention relates to a lithographic method, a lithographic system, an electron beam flooding tool and an inline electron beam flooding tool.

### BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Semiconductor feature sizes continue to shrink. As a result, during lithographic processes, the feature sizes of the pattern to be projected onto a substrate continue to shrink. At shrinking dimensions, imaging errors may occur as a result of imaging errors, e.g. as a result of diffraction effects. An existing technique to take account of such errors is optical proximity correction. Thereby, the pattern of the patterning device is modified in a process development phase to at least partly compensate for such imaging errors. In the process development phase, the actual pattern as projected onto the substrate may be imaged by a Scanning Electron Microscope (SEM) or other electron microscope, so as to enable to compare the actual pattern on the substrate to the intended pattern, thus enabling further optimization.

As a further development, the optical proximity correction has advanced towards source mask optimization techniques. In these optimization techniques, 3 dimensional effects of the patterning device, and/or 3 dimensional effects of the substrate (e.g. a 3 dimensional resist substrate profile) may be taken into account. Again, in the process development phase, the actual pattern as projected onto the substrate may be imaged by a Scanning Electron Microscope (SEM) or other electron microscope, so as to enable to compare the actual pattern on the substrate to the intended pattern, thus enabling further optimization.

Despite these optimization techniques in the process development phase, error margins may be observed in a manufacturing phase

### SUMMARY OF THE INVENTION

It is desirable to project a pattern from a patterning device onto a substrate at a low error margin.

According to an aspect of the invention, there is provided a lithographic method comprising:
- providing a patterning device being capable of imparting a radiation beam with a pattern in its cross-section to form a patterned radiation beam,
- projecting by the radiation beam the pattern from the patterning device onto a substrate to provide a patterned substrate, and
- flooding the patterned substrate by an electron beam.

According to another aspect of the invention, there is provided a lithographic system comprising:
a lithographic apparatus arranged to project a pattern from a patterning device onto a substrate, and
an electron beam flooding tool arranged to flood the substrate by an electron beam,
wherein the electron beam flooding tool is arranged downstream of the lithographic apparatus.

According to a further aspect of the invention, there is provided an electron beam flooding tool arranged to flood a patterned substrate by an electron beam.

According to a still further aspect of the invention, there is provided an inline electron beam flooding tool arranged to flood a patterned substrate by an electron beam, the inline electron beam flooding tool being configured to be arranged in a lithographic apparatus substrate track of a lithographic apparatus.

### BRIEF DESCRIPTION OF THE DRAWINGS

Embodiments of the invention will now be described, by way of example only, with reference to the accompanying schematic drawings in which corresponding reference symbols indicate corresponding parts, and in which:
- Figure 1 depicts a lithographic apparatus as may be applied in embodiments of the invention;
- Figure 2a - 2e depict process steps of a pattern created by a lithographic method;
- Figure 3 depicts a flow diagram of a lithographic method;
- Figure 4 depicts a flow diagram of an embodiment of the lithographic method; and
- Figure 5a and 5b each depict an embodiments of an electron beam flooding tool;
- Figure 6 depicts a graph of critical dimension versus irradiation dose; and
- Figure 7 depicts a schematic view of a lithographic system.

### DETAILED DESCRIPTION

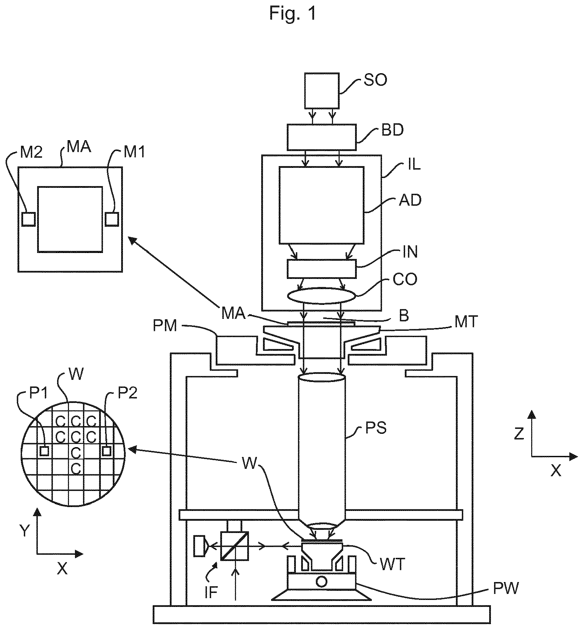

Figure 1 schematically depicts a lithographic apparatus according to one embodiment of the invention. The apparatus comprises an illumination system IL, a support structure MT, a substrate table WT and a projection system PS.

The illumination system IL is configured to condition a radiation beam B. The support structure MT (e.g. a mask table) is constructed to support a patterning device MA (e.g. a mask) and connected to a first positioner PM configured to accurately position the patterning device in accordance with certain parameters. The substrate table WT (e.g. a wafer table) is constructed to hold a substrate W (e.g. a resist-coated wafer) W and connected to a second positioner PW configured to accurately position the substrate in accordance with certain parameters. The projection system PS is configured to project a pattern imparted to the radiation beam B by patterning device MA onto a target portion C (e.g. comprising one or more dies) of the substrate W.

The illumination system IL may include various types of optical components, such as refractive, reflective, magnetic, electromagnetic, electrostatic or other types of optical components, or any combination thereof, for directing, shaping, or controlling radiation.

The term "radiation beam" used herein encompass all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

The support structure MT supports, i.e. bears the weight of, the patterning device MA. The support structure MT holds the patterning device MA in a manner that depends on the orientation of the patterning device MA, the design of the lithographic apparatus, and other conditions, such as for example whether or not the patterning device MA is held in a vacuum environment. The support structure MT can use mechanical, vacuum, electrostatic or other clamping techniques to hold the patterning device MA. The support structure MT may be a frame or a table, for example, which may be fixed or movable as required. The support structure MT may ensure that the patterning device MA is at a desired position, for example with respect to the projection system PS.

The term "patterning device" used herein should be broadly interpreted as referring to any device that can be used to impart a radiation beam B with a pattern in its cross-section such as to create a pattern in a target portion C of the substrate W. It should be noted that the pattern imparted to the radiation beam B may not exactly correspond to the desired pattern in the target portion C of the substrate W, for example if the pattern includes phase-shifting features or so called assist features. Generally, the pattern imparted to the radiation beam will correspond to a particular functional layer in a device being created in the target portion C, such as an integrated circuit.

The patterning device MA may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam B in different directions. The tilted mirrors impart a pattern in a radiation beam B which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum.

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables WT (and/or two or more mask tables). In such "multiple stage" machines the additional tables may be used in parallel, or preparatory steps may be carried out on one or more tables while one or more other tables are being used for exposure. In addition to one or more substrate tables WT, the lithographic apparatus may have a measurement stage that is arranged to be at a position beneath the projection system PS when the substrate table WT is away from that position. Instead of supporting a substrate W, the measurement stage may be provided with sensors to measure properties of the lithographic apparatus. For example, the projection system may project an image on a sensor on the measurement stage to determine an image quality.

The lithographic apparatus may also be of a type wherein at least a portion of the substrate W may be covered by a liquid having a relatively high refractive index, e.g. water, so as to fill a space between the projection system and the substrate. An immersion liquid may also be applied to other spaces in the lithographic apparatus, for example, between the patterning device MA and the projection system PS. Immersion techniques are well known in the art for increasing the numerical aperture of projection systems. The term "immersion" as used herein does not mean that a structure, such as a substrate W, must be submerged in liquid, but rather only means that liquid is located between the projection system PS and the substrate W during exposure.

Referring to figure 1, the illumination system IL receives a radiation beam B from a radiation source SO. The radiation source SO and the lithographic apparatus may be separate entities, for example when the radiation source SO is an excimer laser. In such cases, the source is not considered to form part of the lithographic apparatus and the radiation beam B is passed from the radiation source SO to the illumination system IL with the aid of a beam delivery system BD comprising, for example, suitable directing mirrors and/or a beam expander. In other cases the radiation source SO may be an integral part of the lithographic apparatus, for example when the radiation source SO is a mercury lamp. The radiation source SO and the illuminator IL, together with the beam delivery system BD if required, may be referred to as a radiation system.

The illumination system IL may comprise an adjuster AD for adjusting the angular intensity distribution of the radiation beam B. Generally, at least the outer and/or inner radial extent (commonly referred to as σ-outer and σ-inner, respectively) of the intensity distribution in a pupil plane of the illumination system can be adjusted. In addition, the illumination system IL may comprise various other components, such as an integrator IN and a condenser CO. The illumination system IL may be used to condition the radiation beam B, to have a desired uniformity and intensity distribution in its cross-section.

The radiation beam B is incident on the patterning device MT, which is held on the support structure MT, and is patterned by the patterning device MA. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module and a short-stroke module, which form part of the first positioner PM. The long-stroke module may provide coarse positioning of the short-stroke module over a large range of movement. The short-stroke module may provide fine positioning of the support structure MT relative to the long-stroke module over a small range of movement. Similarly, movement of the substrate table WT may be realized using a long-stroke module and a short-stroke module, which form part of the second positioner PW. The long-stroke module may provide coarse positioning of the short-stroke module over a large range of movement. The short-stroke module may provide fine positioning of the substrate table WT relative to the long-stroke module over a small range of movement. In the case of a stepper (as opposed to a scanner) the support structure MT may be connected to a short-stroke actuator only, or may be fixed. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions C (these are known as scribe-lane alignment marks). Similarly, in situations in which more than one die is provided on the patterning device MA, the mask alignment marks M1, M2 may be located between the dies.

The depicted apparatus could be used in at least one of the following modes:
In a first mode, the so-called step mode, the support structure MT and the substrate table WT are kept essentially stationary, while an entire pattern imparted to the radiation beam B is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.
In a second mode, the so-called scan mode, the support structure MT and the substrate table WT are scanned synchronously while a pattern imparted to the radiation beam B is projected onto a target portion C (i.e. a single dynamic exposure). The velocity and direction of the substrate table WT relative to the support structure MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
In a third mode, the support structure MT is kept essentially stationary holding a programmable patterning device, and the substrate table WT is moved or scanned while a pattern imparted to the radiation beam B is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

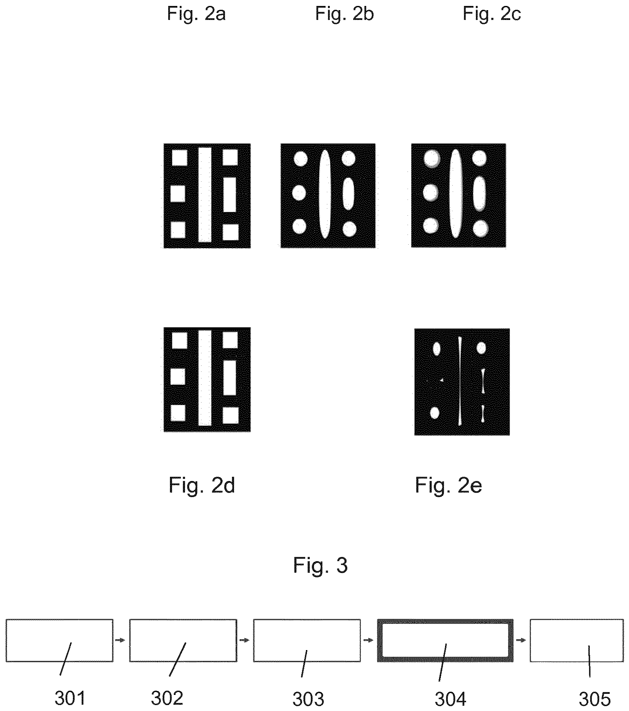

Figure 2a - 2c illustrate a process development phase of a lithographic process. Figure 2d and 2e illustrate a manufacturing phase of the lithographic process. Figure 2a illustrates a part of a pattern of a patterning device as is to be projected onto a substrate. Figure 2b depicts a Scanning Electron Microscope (SEM) image of the pattern after it has been projected onto the substrate. Specifically, in the present embodiment, the inspection is performed after development of the substrate, i.e. after development of the resist layer thereof. Figure 2c depicts a following image obtained e.g. by the SEM after having etched the substrate. It is noted that the obtained pattern may not fully correspond to the pattern of the patterning device. For example, diffraction effects and other projection errors may play a role to alter a form of the pattern when projected from the patterning device onto the substrate. Furthermore, with the etching, again some modification of the pattern may take place. The pattern of the patterning device may have taken these effects into account, hence the pattern of the patterning device (Fig. 1A) may be modified in respect of the intended pattern. Thereby, edge effects and other effects may at least partly be compensated. Accordingly, a pattern is obtained on the substrate which corresponds, within process constraints, to an intended pattern from the patterning device.

Once the pattern as obtained on the substrate appears to meet specifications, a volume production, i.e. manufacturing, may be started. In such manufacturing phase, in the present illustrative example, it appears that a projection of the pattern (Fig. 2d) on the substrate results in pattern on the substrate, after etching, as depicted in Figure 2e. As illustrated in Figure 2e, the pattern as resulting on a substrate in the manufacturing phase may deviate from the pattern as resulting on a substrate in the process development phase. It is noted that the difference between Figures 2c and 2e is for illustrative purpose only. An actual differences as obtained between patterns in the process development phase and the manufacturing phase may deviate from each other more or less than the illustrated deviations.

According to an aspect of the invention, a lithographic method comprises providing a patterning device. When irradiated by a radiation beam, a pattern of the patterning device is projected onto a substrate. The patterned substrate is flooded by an electron beam.

The pattern of the patterning device is projected onto a substrate. Thereto, the patterning device may be irradiated by a radiation beam. The radiation beam may be conditioned by an illumination system. The pattern as projected onto the substrate may then be flooded by an electron beam. By the flooding, electrons of the electron beam are applied to a top layer of the substrate, such as the (photo)resist. As a result of the irradiation by the electron beam, some interaction with the substrate, e.g. some degree of degradation of the substrate, in particular some degree of degradation of a top layer thereof, such as a resist layer, may occur.

In a process development phase that has resulted in the patterning device, an irradiation of the development substrate may have taken place, for example in that the pattern as projected onto the substrate in the process development phase may have been inspected by an electron beam, for example an electron beam of a Scanning Electron Microscope. (SEM). The image obtained by means of the electron beam imaging may have been applied to optimize the pattern of the patterning device. The irradiation by the electron beam may however have brought about an interaction of the electrons with a top layer of the substrate, such as the photoresist layer.

The flooding by the electron beam, in the manufacturing phase, may provide for an amount of damage similar to, or comparable to, the damage provided in the process development phase by the electron beam of the Scanning Electron Microscope. In the process development phase, the image obtained from the electron microscope is applied to further develop the lithographic process. Thus, the interaction of the electron beam with the substrate, e.g. the interaction of the electron beam with the photoresist layer of the substrate, may have an effect in the process development phase. For example, the scanning of the development substrate by the electron beam may result in a shrinkage of the photo resist. Other effects in the resist may take place as well, such as charging the resist or contaminating the resist by carbon deposition. Optimization of the patterning device, during the process development phase, may take the image obtained by the electron microscope into account. Hence an effect of the electron beam on the development substrate, may translate into the obtained patterning device. The flooding of the patterned substrate in the manufacturing phase may make the resist in the manufacturing phase to be more close to the optimized resist as obtained in the process development.

The flooding may provide for electrons onto the surface of the substrate substantially without providing a surface charge to the substrate. Thereto, purging gas may dissipate the surface charge from the substrate. In an embodiment, the purging gas may be ionized to enhance the surface charge dissipation.

The flooding may flood the substrate with electrons having a landing energy in a range of 1 electron Volt (eV) - 50000 electron Volts (eV). which may enable application of the flooding in the case of the scanning of the substrate in the development phase by various techniques, such as LEEM, SEM, HV SEM, etc.. As a Scanning Electron Microscope, as employed in the process development phase, may make use of an electron beam employing a similar landing energy, an effect of the flooding on the top layer of the substrate may be similar to an effect by the Scanning Electron Microscope on the development substrate. For example the electrons may reach a similar depth in the top layer of the substrate (the photoresist). A CD (or 2D) representation of the pattern may be employed. This may require landing energy below 1 kV. Applications wherein a profile shape (3D) of the pattern is derived may need to accommodate higher landing energies, e.g. up to 30 keV.

A large surface area of the patterned substrate may be irradiated at once, providing for a short irradiation time by the electron beam, thus a relatively short processing time. For example, an entire patterned area of the surface of the substrate may be flooded simultaneously. Hence, the entire surface of the substrate on which the pattern has been projected (e.g. the entire top surface except the edges thereof) may be irradiated simultaneously to shorten a processing time of such irradiation. Alternatively, the patterned substrate may be irradiated by a small spot electron beam, such as an electron beam of a Scanning Electron Microscope. In another alternative, an electron beam slit may be irradiated on the substrate, e.g. in combination with a conveying of the substrate relative to the electron beam slit. The substrate may be conveyed in a direction perpendicular to the electron beam slit. The electron beam slit and the substrate may move relative to each other to provide that the electron beam slit exposes the patterned surface of the substrate in a scanning type of movement so as to scan the surface of the substrate by moving the slit in respect of the surface of the substrate.

In an embodiment, the irradiating the patterned substrate by the electron beam comprises irradiating an entire patterned surface of the substrate by the electron beam. Hence an effect of the electron beam flooding on the substrate, e.g. the resist layer thereof, may extend over the entire patterned surface of the substrate.

In an embodiment, the method comprises developing the substrate prior to irradiating the patterned substrate by the electron beam. By the developing of the substrate, i.e. the (photo)resist layer, the topography that has been provided on the substrate by the protecting of the pattern on the substrate, may be transformed from a latent pattern chemically in the resist (as a result of the irradiation on the (photo)resist) into a resist topography pattern. As a following step, parts of the resist may be etched away. In an alternative embodiment, the flooding may be applied before developing the substrate, i.e. the electron beam flooding being applied to the latent pattern on the substrate. For some types of the resist, flooding the resist by an electron beam prior to the developing, may provide a more or less similar effect as the electron beam flooding after the developing.

The patterning device may have been optimized to take account of deviations in the projection process. The deviations may be due to any effect, such as diffraction or 3 dimensional (3D) effects of the patterning device and/or of the substrate. Generally speaking, the patterning device may have been modified to at least partly compensate for distortions in the obtained pattern of the substrate as compared to the intended pattern on the substrate. Thus, the modified pattern of the patterning device aims to reproduce on the substrate, the intended pattern reflecting an intended lay out on the substrate.

The inspection by the electron beam may result in an inspection image of the pattern as projected onto the development substrate. Deviations between the pattern as projected onto the substrate and the pattern as intended on the substrate may be derived from the inspection image. The pattern of the patterning device may then be modified to at least partly compensate for any deviations between the intended pattern and the pattern obtained from the inspection image.

The above described lithographic method is illustrated in the flow diagram depicted in Figure 3. In step 301, a patterning device comprising a pattern is provided. In step 302, a (photo)resist layer of the substrate is exposed by projecting the pattern from the patterning device onto the substrate, using a radiation beam generated by an illumination system. The radiation beam may be a DUV radiation beam or an EUV radiation beam. In step 303, the irradiated photoresist is developed. In step 304, the substrate having the developed photoresist layer is flooded by an electron beam. Then, in step 305, the substrate is etched so as to etch the developed photoresist. Further processing steps, such as depositions, ion implantation, etc. may follow in order to manufacture a device (such as a semiconductor device) from the substrate. The manufacturing phase as described with reference to Figure 3 may be a high volume manufacturing involving plural substrates and resulting in plural, e.g. identically processed substrates.

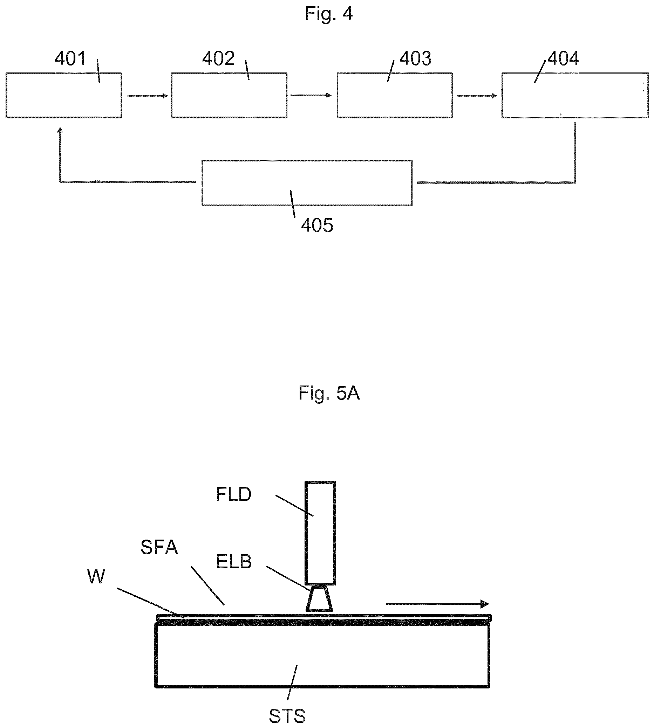

The process development phase in which the patterning device is developed, is described with reference to the flow diagram as depicted in Figure 4. In step 401, a patterning device comprising a pattern is manufactured. Initially, the pattern of the patterning device may be a pattern without any corrections, i.e. a pattern corresponding to the intended pattern as intended to result on the substrate. Alternatively, the initial pattern may embody an iteration to take into account a two dimensional or three dimensional modelling of the pattern and/or the substrate surface. For example, a model of diffraction effects and/or a relief of the substrate may be taken into account in the initial pattern. The modelling may make use of a computational lithography model. As a following step, in 402, a (photo)resist layer of the substrate is exposed by projecting the pattern from the patterning device onto the substrate, using a radiation beam generated by an illumination system. The radiation beam may be a DUV radiation beam or an EUV radiation beam. In step 403, the irradiated photoresist is developed. In step 404, the substrate having the developed photoresist layer is subjected to an After Development Inspection making use of an electron microscope, such as a Scanning Electron Microscope (SEM). The After Development Inspection provides an inspection image of the developed substrate, in particular an inspection image of the developed photoresist layer of the substrate. The pattern in the developed photoresist layer may exhibit deviations when compared to the intended pattern. Then, in step 405, the inspection image of the developed photoresist is employed to optimize the computational lithography model. As a next iteration, an improved mask pattern is produced in order to take account of the deviations between the inspection image of the developed photoresist layer and the intended pattern. The described process development steps may iteratively be carried out, in order to adapt the pattern of the patterning device so as to provide that a projection of the pattern of the patterning device onto the substrate reproduces the intended pattern with a sufficient degree of precision, thus at least partly compensating imaging errors.

The optimization of the pattern may employ any suitable modelling technique. For example, Optical Proximity Correction, OPC, may be employed providing for a two dimensional modelling. More advanced modelling techniques, such as three dimensional modelling techniques that take account of a three dimensional shape of the pattern on the patterning device and/or a three dimensional shape of the resist layer on the substrate may be employed as well. Examples include irradiation source optimization, patterning device optimization (also referred to as mask optimization) or source mask optimization.

By the flooding in step 304, the resist layer is affected in the manufacturing phase, providing to some extent, a similar affecting of the resist layer in the development phase. Thus, effects on the resist layer as encountered in the process development phase nay be invoked in the manufacturing phase to provide more similar circumstances in the process development and the manufacturing phases.

According to an aspect of the invention, an electron beam flooding tool is provided. The electron beam flooding tool is arranged to flood a patterned substrate by an electron beam.

Figure 5a depicts an embodiment of a flooding tool, which comprises an electron beam flooding device FLD which irradiates an electron beam ELB onto a surface area SFA of the substrate W. The flooding tool may further comprises a substrate transport system STS, such as a conveyor, which moves the substrate W while being irradiated by the flooding device. In the depicted exemplary configuration, the substrate is moved from left to right. In an embodiment, the flooding device is configured to generate an electron beam slit having a width substantially corresponding to the width (e.g. diameter) of the substrate. The slit may extend perpendicular to the direction of movement of the conveyor. Hence, the flooding device may enable to irradiate the surface of the substrate W while the substrate transport system STS conveys the substrate in respect of the electron beam.

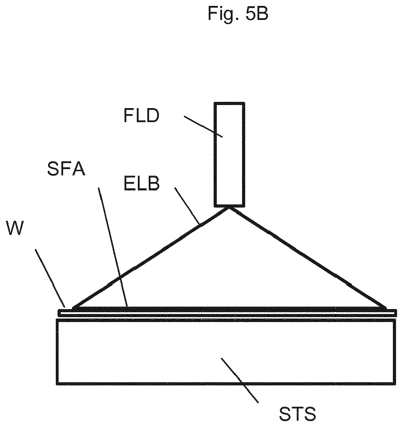

In another embodiment as schematically depicted in Figure 5b, the electron beam ELB emitted by the flooding device FLD floods the entire patterned surface area SFA if the substrate W at a time. The flooding device may accordingly be arranged to emit a divergent electron beam to flood the entire (patterned) surface area of the substrate at once. A substrate transport system STS may be provided to convey the substrate, for example along a lithographic track of a lithographic system. For example, the substrate transport system may convey the substrate to the position as shown, after which the electron beam flooding device emits the electron beam onto the substrate. Upon completion of the flooding, the substrate transport system may convey the substrate away from the flooding device.

As an alternative to irradiating the entire substrate or the entire patterned surface area of the substrate, specific parts of the surface of the substrate may be irradiated (e.g.. flooded). For example, a part of the patterned substrate may be irradiated by the electron beam, which part corresponds to a part of the development substrate which part has been inspected by the inspection electron beam. Thus, specifically at the parts of the development substrate, where the irradiation by the Scanning Electron Microscope may have resulted in a damaging (e.g. shrinkage) of the photoresist layer, a compensation effect may be achieved by the flooding of these parts of the substrate by the electron beam during the manufacturing.

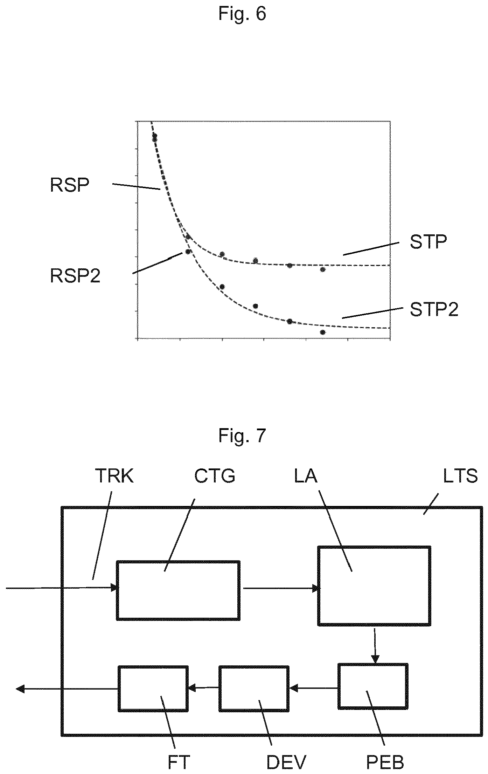

Figure 6 depicts a curve of a critical dimension of the pattern versus a dose of the electron beam exposure, such as the electron beam exposure by the Scanning Electron Microscope. The term dose may be understood as a charge per square nanometer. As depicted in Figure 6, the curve exhibits a rising part RSP and a saturating part STP. In the rising part, an increase in the electron beam exposure results in a decrease in critical dimension, while in the saturating part, a relatively low decrease in critical dimension occurs as the electron beam exposure increases.

In an embodiment, the exposure by the flooding is in the saturating part. As a result, some deviations in the exposure, e.g. the flooding exposure and/or the scanning electron microscope exposure in the development phase, may have a lower effect on the damage of the resist due to the electron beam.

Figure 6 further depicts a second curve, showing a second rising part RSP2 and a second saturating part STP2. The second rising part RSP2 and the second saturating part STP2 may apply at a different landing energy of the electrons of the electron beam.

The electron beam flooding may not only be employed in the manufacturing phase. Rather, the flooding may also be employed in the process development phase. For example, in the process development phase only specific parts of the pattern projected on the development substrate may be inspected by the electron beam. In that case, in the process development phase, the effects of the inspection electron beam on the substrate may only be invoked locally, namely at the area's where the electron beam is applied for inspection. Hence, other areas of the development substrate may nog be affected by the electron beam. Flooding the substrate by the electron beam in the development phase may bring the damage to the substrate into the saturation phase. Thus, additional damage by the local electron beam inspection, e.g. by a Scanning Electron Microscope, may be low. Therefore, local variations as a result of local electron beam inspection or a local refraining thereof, may be prevented. Hence, an overall effect of the electron beam on the development substrate may be more defined, as local variations in damage may be prevented.

According to an aspect of the invention, a lithographic system is provided, the lithographic system comprise a lithographic apparatus arranged to project a pattern from a patterning device onto a substrate, such as for example the lithographic apparatus described with reference to Figure 1, and an electron beam flooding tool arranged to flood the substrate by an electron beam, such as described with reference to Figures 3 - 6. The electron beam flooding tool may be arranged downstream of the lithographic apparatus. Thus, once a pattern has been projected onto the top layer of the substrate, e.g. the (photo)resist, the flooding of the substrate may be performed as described above with reference to Figures 3 - 6.

A schematic view of a lithographic system LTS is described with reference to Figure 7. The lithographic system comprises a lithographic track TRK, along which substrates W are processed. The processing may comprise a coating device CTG for coating the substrate, for example a coating by a (photo) resist. The coated substrate is transferred to the lithographic apparatus LA of the lithography system, where the substrate is exposed by a patterned radiation beam to impart a pattern on the substrate. After the substrate has been patterned, the substrate is transferred to a Post Exposure Baking device PEB, and a Developer DEV where the patterned substrate, in particular the patterned resist, is developed. According to the present invention, a flooding tool FT as described above with reference to Figures 3 - 6, is arranged in the lithography system. In the embodiment as schematically depicted in Figure 7, the flooding tool is arranged downstream of the developer so as to flood the developed, patterned substrate. As a result, a similar damaging, e.g. shrinkage, of the resist layer is provided as encountered as a result of the inspection by a Scanning Electron Microscope during a development of the patterning device.

The flooding tool may be arranged in line in the track of the lithographic system, thereby to flood the substrates as they are transported along the track of the lithographic system. For example, the flooding tool may be arranged to flood the substrate during a passing of the substrate along the track of the lithographic system.

In another embodiment the electron beam flooding tool is arranged in the lithographic apparatus, For example, the flooding tool may be arranged along a track of the substrates near an exit of the lithographic apparatus. The substrates exposed by the lithographic apparatus may hence be flooded by the electron beam flooding tool before exiting the lithographic apparatus at an exit thereof. The electron beam flooding tool may for example be arranged in a vacuum chamber of a lithographic apparatus, such as a vacuum chamber of an EUV lithographic apparatus. Hence, the electron beam flooding may be integrated into a clean room arrangement at a minimum of additional floor space or at no additional floor space. It will be understood that, within the context of the present invention, the lithographic system may also comprise an electron beam flooding tool that is remote from the lithographic apparatus.

Embodiments may further be described using the following clauses:
1. A lithographic method comprising:
   - providing a patterning device being capable of imparting a radiation beam with a pattern in its cross-section to form a patterned radiation beam,
   - projecting by the radiation beam the pattern from the patterning device onto a substrate to provide a patterned substrate, and
   - flooding the patterned substrate by an electron beam.
2. The lithographic method according to clause 1, comprising developing the substrate prior to flooding the patterned substrate by the electron beam.
3. The lithographic method according to clause 1 or 2, wherein a landing energy of electrons of the electron beam is between 1 electron Volt and 50000 electron Volt.
4. The lithographic method according to any one of the preceding clauses, wherein a dose of the electron beam being set to saturate a damaging of the patterned substrate.
5. The lithographic method according to any one of the preceding clauses, wherein the flooding the patterned substrate by the electron beam comprises flooding an entire patterned surface of the substrate by the electron beam.
6. The lithographic method according to any one of the preceding clauses, wherein the flooding the patterned substrate by the electron beam comprises flooding a slit of a surface of the substrate.
7. The lithographic method according to clause 6, further comprising conveying the substrate relative to the electron beam in a direction perpendicular to the slit so as to scan the surface of the substrate by moving the slit in respect of the surface of the substrate.
8. The lithographic method according to any one of the preceding clauses, wherein the pattern of the patterning device has been provided by
   - providing a development patterning device;
   - projecting a pattern from the development patterning device onto a development substrate to provide a patterned development substrate;
   - inspecting the patterned development substrate by an inspection electron beam to provide inspection image data;
   - modifying the pattern of the development patterning device using the inspection image data; and
   - manufacturing the patterning device on the basis of the modified pattern.
9. The lithographic method according to clause 8, wherein the flooding the patterned substrate by the electron beam comprises flooding a part of the patterned substrate corresponding to a part of the development substrate inspected by the inspection electron beam.
10. The lithographic method according to clause 8 or 9, wherein a dose of the electron beam corresponds to a dose of the inspection electron beam.
11. The lithographic method according to any one of clauses 8 to 10, wherein the inspecting the patterned development substrate by an inspection electron beam employs a scanning electron microscope.
12. The lithographic method according to any one of clauses 8 to 11, further comprising flooding the patterned development substrate by the electron beam.
13. The lithographic method according to any one of clauses 8 to 12, wherein the flooding the patterned substrate by the electron beam at least partly compensates for a shrinkage of a resist of the patterned development substrate as a result of the inspecting the patterned development substrate by the inspection electron beam.
14. The lithographic method according to any one of clauses 8 to 13, wherein the pattern of the patterning device has been modified using optical proximity correction.
15. The lithographic method according to any one of clauses 8 to 14, wherein the pattern of the patterning device has been modified using at least one of an irradiation source optimisation and a patterning device optimisation.
16. The lithographic method according to any one of the preceding clauses, wherein the flooding the patterned substrate is performed in a vacuum chamber of a lithographic apparatus.
17. The lithographic method according to clause 16, wherein the flooding the patterned substrate is performed before placing the patterned substrate in a load lock of the vacuum chamber.
18. The lithographic method according to any one of the preceding clauses, further comprising etching the irradiated substrate.
19. The lithographic method according to clause 18, further comprising manufacturing a device from the etched substrate.
20. A lithographic system comprising:
   a lithographic apparatus arranged to project a pattern from a patterning device onto a substrate, and
   an electron beam flooding tool arranged to flood the substrate by an electron beam, wherein the electron beam flooding tool is arranged downstream of the lithographic apparatus.
21. The lithographic system according to clause 20, wherein the electron beam flooding tool is arranged inline in a substrate track of the lithographic system.
22. The lithographic system according to clauses 20 or 21, further comprising a developer arranged to develop the substrate, the electron beam flooding tool being arranged downstream of the developer
23. The lithographic system according to any one of clauses 20 to 22, wherein a landing energy of electrons of the electron beam is between 1 electron Volt and 50000 electron Volt.
24. The lithographic system according to any one of clauses 20 to 23, wherein the flooding tool is arranged to flood the substrate at a dose of the electron beam to saturate a damaging of the patterned substrate.
25. The lithographic system according to any one of clauses 20 to 24, wherein the electron beam flooding tool is arranged to flood an entire patterned surface of the substrate by the electron beam.
26. The lithographic system according to any one of clauses 20 to 25, wherein the electron beam flooding tool is arranged to generate a slit shaped electron beam to flood a slit of a surface of the substrate.
27. The lithographic system according to clause 26, further comprising a substrate conveyer system arranged to convey the substrate in a direction perpendicular to the slit so as to scan the surface of the substrate by moving the slit in respect of the surface of the substrate.
28. The lithographic system according to any of clauses 20 to 27, wherein the electron beam flooding tool is arranged in a vacuum chamber of the lithographic apparatus.
29. The lithographic system according to clause 28, wherein the electron beam flooding tool is arranged in the vacuum chamber to perform the flooding the patterned substrate before placing the patterned substrate in the load lock of the vacuum chamber.
30. An electron beam flooding tool arranged to flood a patterned substrate by an electron beam.
31. The electron beam flooding tool according to clause 30, arranged to be placed inline in a substrate track of a lithographic system.
32. The electron beam flooding tool according to clause 30 or 31, wherein the electron beam flooding tool is arranged to be positioned downstream of a developer to develop the patterned substrate.
33. The electron beam flooding tool according to any one of clauses 30 to 32, wherein a landing energy of electrons of the electron beam is between 1 electron Volt and 50000 electron Volt.
34. The electron beam flooding tool according to any one of clauses 30 to 33, wherein the electron beam flooding tool is arranged to flood the substrate at a dose of the electron beam to saturate a damaging of the patterned substrate.
35. The electron beam flooding tool according to any one of clauses 30 to 34, wherein the electron beam flooding tool is arranged for flooding an entire patterned surface of the substrate by the electron beam.
36. The electron beam flooding tool according to any one of clauses 30 to 35, wherein the electron beam flooding tool is arranged to generate a slit shaped electron beam to flood a slit of a surface of the substrate.
37. The electron beam flooding tool according to clause 36, further comprising a substrate conveyer system arranged to convey the substrate in a direction perpendicular to the slit so as to scan the surface of the substrate by moving the slit in respect of the surface of the substrate.
38. An inline electron beam flooding tool arranged to flood a patterned substrate by an electron beam, the inline electron beam flooding tool being configured to be arranged in a lithographic apparatus substrate track of a lithographic apparatus.
39. The inline electron beam flooding tool according to clause 38, wherein the electron beam flooding tool is arranged to be positioned downstream of a developer to develop the patterned substrate.
40. The electron beam flooding tool according to clause 38 or 39, wherein a landing energy of electrons of the electron beam is between 1 electron Volt and 50000 electron Volt.
41. The inline electron beam flooding tool according to any one of clauses 38 to 40, wherein the inline electron beam flooding tool is arranged to flood the substrate at a dose of the electron beam to saturate a damage of the patterned substrate.
42. The inline electron beam flooding tool according to any one of clauses 38 to 41, wherein the electron beam flooding tool is arranged to flood an entire patterned surface of the substrate by the electron beam.
43. The inline electron beam flooding tool according to any one of clauses 38 to 42, wherein the inline electron beam flooding tool is arranged to generate a slit shaped electron beam to flood a slit of a surface of the substrate.
44. The inline electron beam flooding tool according to clause 43, further comprising a substrate conveyer system arranged to convey the substrate in a direction perpendicular to the slit so as to scan the surface of the substrate by moving the slit in respect of the surface of the substrate.

Embodiments as described with reference to one of the lithographic method, the lithographic system, the electron beam flooding tool and the inline electron beam flooding tool may also apply, mutatis mutandis, to other ones of the lithographic method, the lithographic system, the electron beam flooding tool and the inline electron beam flooding tool, providing the same or similar effects.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. A lithographic system comprising:
a lithographic apparatus arranged to project a pattern from a patterning device onto a substrate, and
an electron beam flooding tool arranged to flood the substrate by an electron beam,
wherein the electron beam flooding tool is arranged downstream of the lithographic apparatus.

2. The lithographic system according to claim 1, wherein the electron beam flooding tool is arranged inline in a substrate track of the lithographic system.

3. The lithographic system according to claim 1, further comprising a developer arranged to develop the substrate, the electron beam flooding tool being arranged downstream of the developer

4. The lithographic system according to claim 1, wherein a landing energy of electrons of the electron beam is between 1 electron Volt and 50000 electron Volt.

5. The lithographic system according to claim 1, wherein the flooding tool is arranged to flood the substrate at a dose of the electron beam to saturate a damaging of the patterned substrate.

6. The lithographic system according to claim 1, wherein the electron beam flooding tool is arranged to flood an entire patterned surface of the substrate by the electron beam.

7. The lithographic system according to claim 1, wherein the electron beam flooding tool is arranged to generate a slit shaped electron beam to flood a slit of a surface of the substrate.

8. The lithographic system according to claim 7, further comprising a substrate conveyer system arranged to convey the substrate in a direction perpendicular to the slit so as to scan the surface of the substrate by moving the slit in respect of the surface of the substrate.

9. The lithographic system according to claim 1, wherein the electron beam flooding tool is arranged in a vacuum chamber of the lithographic apparatus.

10. The lithographic system according to claim 9, wherein the electron beam flooding tool is arranged in the vacuum chamber to perform flooding the patterned substrate before placing the patterned substrate in the load lock of the vacuum chamber.

11. An electron beam flooding tool for use in the lithographic system according to claim 1, wherein the flooding tool is arranged to flood a patterned substrate by an electron beam.

12. The electron beam flooding tool according to claim 11, wherein the electron beam flooding tool is arranged to be positioned downstream of a developer to develop the patterned substrate.

13. The electron beam flooding tool according to claim 11, wherein the electron beam flooding tool is arranged to flood the substrate at a dose of the electron beam to saturate a damaging of the patterned substrate.

14. A lithographic method comprising:
- providing a patterning device being capable of imparting a radiation beam with a pattern in its cross-section to form a patterned radiation beam,
- projecting by the radiation beam the pattern from the patterning device onto a substrate to provide a patterned substrate, and
- flooding the patterned substrate by an electron beam.

15. The lithographic method according to claim 14, comprising developing the substrate prior to flooding the patterned substrate by the electron beam.
